# EUROPÄISCHE PATENTANMELDUNG

(11) **EP 4 099 029 A1**
(43) Veröffentlichungstag der Anmeldung: **07.12.2022**
(21) Anmeldenummer: 22174217.4
(22) Anmeldetag: 19.05.2022
(51) Int. Cl.: G01R 27/18, G01R 31/52

(54) **ELEKTRISCHE SCHALTUNGSANORDNUNG ZUR NORMGERECHTEN ISOLATIONSÜBERWACHUNG MIT SCHNELLABSCHALTUNG BEI ERDSCHLUSSERKENNUNG FÜR EIN UNGEERDETES STROMVERSORGUNGSSYSTEM**

(30) Priorität: 02.06.2021 DE 102021114260
(71) Anmelder: Bender GmbH & Co. KG, 35305 Grünberg (DE)
(72) Erfinder: HACKL, Dieter, 35463 Fernwald (DE)
(74) Vertreter: advotec.

(57) **Zusammenfassung**

Die Erfindung betrifft eine elektrische Schaltungsanordnung (2) zur normgerechten Isolationsüberwachung mit Schnellabschaltung bei Erdschlusserkennung für ein ungeerdetes Stromversorgungssystem (4), mit einem normgerechten Isolationsüberwachungsgerät (10), welches netzseitig über jeweils einen Ankoppelzweig (12) an einen aktiven Leiter (L1, L2, L3) des Stromversorgungssystems (4) oder über einen Ankoppelzweig (12) an einen Sternpunkt (S) des Stromversorgungssystems (4) angeschlossen ist und erdseitig über einen Erdanschlusszweig (14) mit Erde (PE) verbunden ist. Die elektrische Schaltungsanordnung (2) weist einen allstromsensitiven Messstromwandler (20) auf, der einen Fehlerstrom netzseitig in den Ankoppelzweigen (12) an die aktiven Leiter (L1, L2, L3) oder in dem Ankoppelzweig (12) an den Sternpunkt (S) oder erdseitig in dem Erdanschlusszweig (14) des Isolationsüberwachungsgerätes (10) erfasst, eine Auswerteeinrichtung (30) zur Bewertung des Fehlerstroms im Hinblick auf eine Überschreitung eines Fehlerstrom-Grenzwertes und eine Schaltvorrichtung (40) zur Abschaltung des Stromversorgungssystems (4).

## Beschreibung

Die Erfindung betrifft eine elektrische Schaltungsanordnung zur normgerechten Isolationsüberwachung mit Schnellabschaltung bei Erdschlusserkennung für ein ungeerdetes Stromversorgungssystem, mit einem normgerechten Isolationsüberwachungsgerät, welches netzseitig über jeweils einen Ankoppelzweig an einen aktiven Leiter des Stromversorgungssystems oder über einen Ankoppelzweig an einen Sternpunkt des Stromversorgungssystems angeschlossen ist und erdseitig über einen Erdanschlusszweig mit Erde verbunden ist.

Für die Versorgung von elektrischen Betriebsmitteln kommt bei erhöhten Anforderungen an die Betriebs-, Brand- und Berührungssicherheit die Netzform eines ungeerdeten Stromversorgungssystems zum Einsatz. Diese Netzform wird auch als isoliertes Netz, IT-Netz oder IT-Stromversorgungssystem (frz. Isole Terre - IT) bezeichnet.

Der Vorteil der IT-Netze liegt darin, dass bei einem ersten Isolationsfehler wie beispielsweise einem Erdschluss oder einem Körperschluss die Funktion der elektrischen Betriebsmittel nicht beeinträchtigt wird, da sich wegen des im Idealfall unendlich großen Impedanzwertes zwischen aktiven Leitern (Außenleiter und Neutralleiter) des ungeeerdeten Stromversorgungssystems und Erde in diesem ersten (Isolations-)Fehlerfall kein geschlossener Stromkreis ausbilden kann.

Durch die inhärente Sicherheit des IT-Stromversorgungssystems kann somit eine kontinuierliche Stromversorgung der an das IT-Stromversorgungssystem angeschlossenen Betriebsmittel, d. h. der von dem IT - Stromversorgungssystem gespeisten Verbraucher, auch dann gewährleistet werden, wenn ein erster Isolationsfehler auftritt.

Der elektrische Widerstand des IT-Stromversorgungssystems gegen Erde (Isolationswiderstand - im Fehlerfall auch Isolationsfehler, Isolationsfehlerwiderstand oder Fehlerwiderstand genannt) wird daher gemäß der Norm IEC-61557-8 mit einem Isolationsüberwachungsgerät (engl. Insulation Monitoring Device - IMD), das zwischen einen oder mehreren aktiven Leitern und Erde oder zwischen einen Sternpunkt des IT-Stromversorgungssystems und Erde angekoppelt wird (Funktionserdung), ständig überwacht, da durch einen möglichen weiteren Fehler an einem anderen aktiven Leiter (zweiter Fehler) eine Fehlerschleife entstünde und der dabei fließende Fehlerstrom in Verbindung mit einer Überstrom-Schutzeinrichtung eine Abschaltung der Anlage mit Betriebsstillstand zur Folge hätte.

Bei Anwendungen im Niederspannungsbereich, in denen das IT-Stromversorgungssystem zum Einsatz kommt, wird entsprechend dem Sinn und Zweck des IT-Netzes daher in der Regel der ungestörte Weiterbetrieb der Anlage im Falle eines ersten Erdschlusses angestrebt.

Bei speziellen Anwendungen im Niederspannungsbereich und vor allem bei Anwendungen im Mittelspannungsbereich, in denen das IT-Stromversorgungssystem zum Einsatz kommt, besteht abweichend von dem grundlegenden Anwendungsprinzip des IT-Stromversorgungssystems in bestimmten Betriebssituationen die Forderung, bereits bei einem ersten Isolationsfehler, der eine in dieser Situation als kritisch eingestufte Verlagerungsspannung erzeugt, die elektrische Anlage oder zumindest betroffene fehlerhafte Anlagenteile so schnell wie möglich unter Berücksichtigung geltender Standards abzuschalten.

Dem Stand der Technik gemäß werden in diesen Anlagen zum Erfüllen der Anforderung an eine schnelle Abschaltung im einfachen Erdschlussfall überwiegend Erdschlusswächter bzw. Erdschlussrelais eingesetzt.

Für diese Geräte existiert kein Produktstandard und es sind verschiedene Ausführungen auf dem Markt verfügbar, welche nach unterschiedlichen Methoden arbeiten.

Allen diesen Erdschlusswächtern/-relais ist jedoch gemeinsam, dass sie die Anforderungen an ein normgerechtes Isolationsüberwachungsgerät nach IEC61557-8 nicht erfüllen und somit beispielsweise schleichend entstehende symmetrische Isolationsfehler nicht erkennen können.

In modernen elektrischen Anlagen sowohl im Niederspannungs- wie auch im Mittelspannungsbereich, welche auf der ungeerdeten Netzform beruhen, besteht zunehmend die Anforderung, beide Überwachungsfunktionen parallel umzusetzen - also eine Isolationsüberwachung nach IEC61557-8 und eine Erdschlusswächterfunktion, die für eine Schnellabschaltung der Anlagen oder von Anlagenteilen sorgt, wenn ein kritischer Betriebszustand erkannt wird - ohne dass diese beiden Überwachungsaufgaben sich gegenseitig stören.

Aus der Patentschrift DE 10 2015 207 456 B3 sind ein Isolationsüberwachungsgerät sowie ein Verfahren zur normgerechten Überwachung eines Isolationswiderstandes eines ungeerdeten ein- oder mehrphasigen Stromversorgungssystems bekannt. Das Isolationsüberwachungsgerät weist zusätzlich eine Spannungsüberwachungsschaltung auf, um permanent für mindestens einen aktiven Leiter die Leiterspannung gegenüber Erdpotential zu erfassen. Wird dabei an einem aktiven Leiter eine Spannungsüberhöhung festgestellt, erzeugt die Spannungsüberwachungsschaltung ein Abschaltsignal, um das Stromversorgungssystem abzuschalten.

Mit einem derartigen durch eine Spannungsüberwachungsschaltung erweiterten und somit speziellen Isolationsüberwachungsgerät kann die Forderung nach einer normgerechten Isolationsüberwachung kombiniert mit einer Art Erdschlusswächterfunktion erfüllt werden.

In der Offenlegungsschrift EP 2 848 949 A1 werden ein Verfahren und eine Vorrichtung beschrieben, in der eine Isolations-überwachungsfunktion mit einer Art Erdschlusswächterfunktion kombiniert wird. Wegen der Besonderheit der Synchronisation mit der Netzfrequenz des zu überwachenden IT-Systems ist die Anwendung dieses Verfahrens ist auf reine AC IT-Systeme mit einer relativ kleinen zulässigen Netzableitkapazität beschränkt.

Als Nachteil bei den bekannten Verfahren und Vorrichtungen erweist sich, dass eine Nachrüstung der Erdschlusswächterfunktion in Kombination mit einem beliebigen, eventuell bereits in einer Anlage vorhandenen, normgerechten Isolationsüberwachungsgerät nach IEC61557-8 nicht realisierbar ist. Die jeweiligen implementierten (Mess-) Kanäle und Signalverarbeitungspfade für die Isolationsüberwachung einerseits und die Erdschlusswächterfunktion andererseits sind nicht voneinander unabhängig, da die bekannten Verfahren und Vorrichtungen Sonderlösungen für spezielle Anwendungsfälle darstellen. Auch würde die Erdschlusswächterfunktion, welche auf einer Messung der Spannung eines aktiven Leiters gegen Erde in einem gemeinsamen Gerät basiert, insbesondere bei Stromversorgungssystemen mit größeren Nennspannungen, also zum Beispiel bei zu überwachenden Mittelspannungssystemen, zu erhöhten Anforderungen an die Isolationskoordination in einer kombinierten Vorrichtung führen.

Der vorliegenden Erfindung liegt somit die Aufgabe zu Grunde, eine normgerechte Isolationsüberwachung mit einer Erdschlusserkennung in der Weise zu kombinieren, dass beide Sicherheitsmaßnahmen unabhängig voneinander wirksam sind ohne sich in ihrer Funktion gegenseitig negativ zu beeinflussen, so dass eine Nachrüstbarkeit der normgerechten Isolationsüberwachung durch die Erdschlusserkennung in schaltungstechnisch einfacher Weise möglich ist.

Diese Aufgabe wird in Verbindung mit den Merkmalen des Oberbegriffs in Anspruch 1 dadurch gelöst, dass die elektrische Schaltungsanordnung einen allstromsensitiven Messstromwandler aufweist, der einen Fehlerstrom netzseitig in den Ankoppelzweigen an die aktiven Leiter oder in dem Ankoppelzweig an den Sternpunkt oder erdseitig in dem Erdanschlusszweig des Isolationsüberwachungsgerätes erfasst, sowie eine Auswerteeinrichtung zur Bewertung des Fehlerstroms im Hinblick auf eine Überschreitung eines Fehlerstrom-Grenzwertes und eine Schaltvorrichtung zur Abschaltung des Stromversorgungssystems.

Ausgangspunkt der Betrachtungen ist die für Isolationsüberwachungsgeräte geltende Produktnorm IEC 61557-8, in der die Anforderung festgeschrieben ist, dass der Innenwiderstand Ri ebenso wie die Wechselstrominnenimpedanz Zi des Isolationsüberwachungsgerätes mindestens 30 Ohm/V der Netznennspannung betragen müssen.

Aufgrund dieser Anforderung ist der Stromfluss bei einem niederohmigen Erdschluss an einem aktiven Leiter des zu überwachenden IT-Stromversorgungssystems unabhängig von der Nennspannung und von der Frequenz in dem Ankoppelzweig/den Ankoppelzweigen/dem Erdanschlusszweig des Isolationsüberwachungsgerätes auf Werte unterhalb von 33mA begrenzt. Der oder die Ankoppelzweige bilden zusammen mit dem Erdanschlusszweig einen Messzweig, in dem der normgemäß begrenzte Fehlerstrom von dem mit dem Isolationsüberwachungsgerät in Reihe geschalteten Messstromwandler erfasst wird.

Erfindungsgemäß wird diese von der Norm vorgegebene Strombegrenzung dazu genutzt, kleine und kostengünstige allstromsensitive Messstromwandler als Stromsensoren zur Erdschlusserkennung und damit als Basiselement für die Erdschlussüberwachungsfunktion einzusetzen. Die Messstromwandler erlauben eine galvanisch getrennte und komplett eigenständige Erfassung eines Erdschlusszustandes durch allstromsensitive Erfassung eines Fehlerstroms in dem oder den Ankoppelzweig(en) oder in dem Erdanschlusszweig des Isolationsüberwachungsgerätes.

Ausgehend von den schaltungstechnischen Vorgaben bei der Anordnung des Isolationsüberwachungsgerätes, welche bestimmt sind durch die Art des Stroms (Wechselstrom (AC), Gleichstrom (DC)), die Art und Anzahl der Leiter (ein- oder mehrphasiges Stromversorgungssystem, mit/ohne mitgeführtem Neutralleiter) sowie durch baulichen Gegebenheiten (Schaltschrank), existieren verschiedene Möglichkeiten, den Messstromwandler in dem aus dem/den Ankopplungszweig(en) und dem Erdanschlusszweig bestehenden Messzweig in einer Reihenschaltung mit dem Isolationsüberwachungsgerät zu installieren.

Erfindungsgemäß ist der Messstromwandler netzseitig grundsätzlich so angeordnet, dass der gesamte, über alle Ankoppelzweige fließende Fehlerstrom erfasst wird. Dies gilt sowohl für ungeerdete Wechselstrom-Stromversorgungssysteme wie für ungeerdete Gleichstrom-Stromversorgungssysteme.

Alternativ dazu ist der Messstromwandler in einem dreiphasigen Wechselstrom-Stromversorgungssystem mit zugänglichem Sternpunkt in dem an den Sternpunkt führenden Ankoppelzweig angeordnet.

In einer weiteren Alternative ist der Messstromwandler - für ungeerdete Wechselstrom-Stromversorgungssysteme wie für ungeerdete Gleichstrom-Stromversorgungssysteme - erdseitig in dem Erdanschlusszweig des Isolationsüberwachungsgerätes angeordnet.

In allen Konstellationen erfasst der Messstromwandler den gesamten Fehlerstrom, der über die aktiven Leiter des Stromversorgungssystems gegen Erde abgeleitet wird.

Die elektrische Schaltungsanordnung weist weiterhin eine Auswerteeinrichtung zur Bewertung des Fehlerstroms im Hinblick auf eine Überschreitung eines Fehlerstrom-Grenzwertes und eine Schaltvorrichtung zur Abschaltung des Stromversorgungssystems auf.

Die Realisierung der Erdschlussüberwachung auf Basis des allstromsensitiven Messstromwandlers erfolgt im Zusammenwirken mit einer geeigneten Auswerteeinrichtung und einer Schaltvorrichtung in der Weise, dass bei Überschreitung des Fehlerstrom-Grenzwertes eine schnelle Abschaltung des zu überwachenden Stromversorgungssystems erfolgt.

Vorzugsweise sind die Auswerteeinrichtung und die Schaltvorrichtung so ausgelegt, dass die Anforderungen an die Abschaltzeiten einer automatischen Abschaltung der Stromversorgung als Fehlerschutz, wie diese in IEC60364-4-41 für das Errichten von Niederspannungsanlagen in Teil 4-41: Schutzmaßnahmen - Schutz gegen elektrischen Schlag (Abschnitt 411) gefordert werden, erfüllt sind. Dies wäre z.B. durch Einsatz eines Differenzstrom-Überwachungsmoduls (MRCD) nach IEC 60947-2 der Fall.

Da die Isolation gegen das Potential des zu überwachenden IT-Stromversorgungssystems durch die feste Isolierung des überwachten aktiven Leiters und den Abstand des überwachten aktiven Leiters zum allstromsensitiven Messstromwandler bestimmt wird, ist diese Erdschlussüberwachung mittels eines allstromsensitiven Messstromwandlers unabhängig vom Nennspannungspegel mit einfachen konstruktiven Maßnahmen und unabhängig vom Typ des eingesetzten Isolationsüberwachungsgerätes nachrüstbar.

Aus der erfindungsgemäßen elektrischen Schaltungsanordnung, welche als Hauptkomponenten das normgerechte Isolationsüberwachungsgerät zur Isolationsüberwachung und den allstromsensitiven Messstromwandler zur Erdschlusserkennung mit Schnellabschaltung durch die Auswerteeinrichtung und die Schaltvorrichtung umfasst, ergeben sich insbesondere die nachfolgend genannten, vorteilhaften technischen Wirkungen, nämlich
- dass sich die Isolationsüberwachung und die zusätzliche Erdschlussüberwachung in ihrer jeweiligen Funktion gegenseitig nicht negativ beeinflussen
- dass beliebige marktverfügbare Isolationsüberwachungsüberwachungsgeräte die ihnen zugedachte Funktion der Isolationsüberwachung übernehmen und die allstromsensitive Erdschlussüberwachungsfunktion mit schneller Abschaltung einfach nachgerüstet werden kann
- dass die Erdschlussüberwachungsfunktion durch einen separaten diversitären Kanal eine erhöhte Zuverlässigkeit und eine hohe Flexibilität in der Auslegung der Erdschlussüberwachungsfunktion bietet
- dass die Erdschlussüberwachung allstromsensitiv, d.h. für Gleichstrom-Stromversorgungssysteme (DC) und für Wechselstrom-Stromversorgungssysteme (AC) einsetzbar ist
- dass die Erdschlussüberwachung für DC- und für verschiedene AC-Frequenzbereiche unterschiedlich empfindlich ausgelegt werden kann
- dass die Erdschlussüberwachungsfunktion auch bei Mittelspannungssystemen nicht zu erhöhten Anforderungen an die Isolationskoordination des Isolationsüberwachungsgerätes führt
- dass die Erdschlussüberwachungsfunktion auch bei Mittelspannungssystemen nicht zu erhöhten Anforderungen an die Isolationskoordination des allstromsensitiven Messstromwandlers führt
- dass die Erdschlussüberwachungsfunktion bei Bedarf so schnell ausgelegt werden kann, dass im Erdschlussfall eine vorbeugende automatische Abschaltung der Stromversorgung mit Abschaltzeiten kleiner als 5s eingehalten werden können, wie diese z.B. in der IEC 60364-4-41 im Abschnitt 411 für die automatische Abschaltung der Stromversorgung als Fehlerschutz gefordert werden
- dass neben einem zusätzlichen Schutz des überwachten IT-Stromversorgungssystems auch ein zusätzlicher Schutz des Isolationsüberwachungsgerätes und/oder eines Ankoppelgerätes für den Fall des Betriebs dieser Komponenten außerhalb ihrer Spezifikation realisiert werden kann.

In weiterer vorteilhafter Ausgestaltung erfasst bei der Verwendung eines Ankoppelgerätes, welches in den Ankoppelzweigen an die aktiven Leiter oder in dem Ankoppelzweig an den Sternpunkt angeschlossen ist und über eine Verbindungsleitung mit dem Isolationsüberwachungsgerät verbunden ist, der Messstromwandler den Fehlerstrom in dem Erdanschlusszweig des Isolationsüberwachungsgerätes oder in der Verbindungsleitung.

In IT-Stromversorgungssystemen, die eine Nennspannung besitzen, welche oberhalb der Isolationskoordination des verwendeten Isolationsüberwachungsgerätes liegen, also beispielweise im Mittelspannungsbereich, kommen Ankoppelgeräte zum Einsatz, welche dafür sorgen, dass die in der Norm IEC61557-8 vorgegebenen Anforderungen eingehalten werden, also dass der Innenwiderstand Ri des Isolationsüberwachungsgerätes mindestens 30 Ohm/V der Netznennspannung betragen muss und die Wechselstrominnenimpedanz Zi des Isolationsüberwachungsgerätes ebenfalls mindestens 30 Ohm/V der Netznennspannung betragen muss.

Um den gesamten Fehlerstrom, der über die aktiven Leiter des Stromversorgungssystems und über das Ankoppelgerät gegen Erde abgeleitet wird, zu erfassen, ist der Messstromwandler in dem Erdanschlusszweig oder in der Verbindungsleitung zwischen IMD und Ankoppelgerät angeordnet.

Die erfindungsgemäß nachrüstbare Erdschlussüberwachung mit einem allstromsensitiven Messstromwandler kann zusätzlich dazu dienen, sicherzustellen, dass die strombegrenzende Funktion des Ankoppelgerätes auch bei hohen Netznennspannungen noch erfüllt wird und bei Überschreiten eines kritischen Stroms, der zum Zusammenbruch der Isolation des Isolationsüberwachungsgerätes führen könnte, eine automatische Abschaltung der Stromversorgung bewirkt wird.

Bevorzugt erfasst bei der Verwendung eines Ankoppelgerätes mit einem Ankoppelgerät-Erdanschluss (Funktionserdung) der Messstromwandler bei der Erfassung des Fehlerstroms in dem Erdanschlusszweig des Isolationsüberwachungsgerätes zusätzlich einen über den Ankoppelgerät-Erdanschluss fließenden Ankoppelgerät-Fehlerstrom.

Einige Ankoppelgeräte besitzen zusätzlich zur Strombegrenzung über den Innenwiderstand bzw. die Innenimpedanz eine Spannungsbegrenzung und hierzu einen eigenen Ankoppelgerät-Erdanschluss.

Der bei einem Erdschluss entstehende Fehlerstrom durch das Ankoppelgerät teilt sich bei Vorhandensein des Ankoppelgerät-Erdanschlusses auf die beiden Funktionserdungsanschlüsse von Isolationsüberwachungsgerät und Ankoppelgerät auf. Um messtechnisch korrekt den kompletten Fehlerstrom durch das Ankoppelgerät zu erfassen, werden erfindungsgemäß sowohl der Erdanschlusszweig des Isolationsüberwachungsgerätes als auch der Ankoppelgerät-Erdanschluss allstromsensitiv durch den Messstromwandler überwacht.

Dies ist vorteilhaft, da der Spannungspegel hier auf Erdpotential liegt und somit keine besonderen Anforderungen an die Isolationskoordination des allstromsensitiven Messstromwandlers gestellt werden.

Weitere vorteilhafte Ausgestaltungsmerkmale ergeben sich aus der nachfolgenden Beschreibung und den Zeichnungen, die eine bevorzugte Ausführungsform der Erfindung anhand von Beispielen erläutern.

Es zeigen:
- **Fig. 1a** bis **1f**: nachrüstbare Anordnungen eines Messstromwandlers in 3AC- und AC-Stromversorgungssystemen;
- **Fig. 2a** bis **2f**: nachrüstbare Anordnungen eines Messstromwandlers in 3AC- und AC-Stromversorgungssystemen mit Ankoppelgerät;
- **Fig. 3a** bis **3c**: nachrüstbare Anordnungen eines Messstromwandlers in 3AC- und AC-Stromversorgungssystemen mit spannungsbegrenzendem Ankoppelgerät;
- **Fig. 4a** bis **4d**: nachrüstbare Anordnungen eines Messstromwandlers in DC-Stromversorgungssystemen;
- **Fig. 5**: nachrüstbare Anordnungen eines Messstromwandlers in AC Stromversorgungssystemen mit Frequenzumrichter und
- **Fig. 6**: eine erfindungsgemäße elektrische Schaltungsanordnung mit normgerechten Isolationsüberwachungsgerät, Messstromwandler, Auswerteeinrichtung und Schaltvorrichtung.

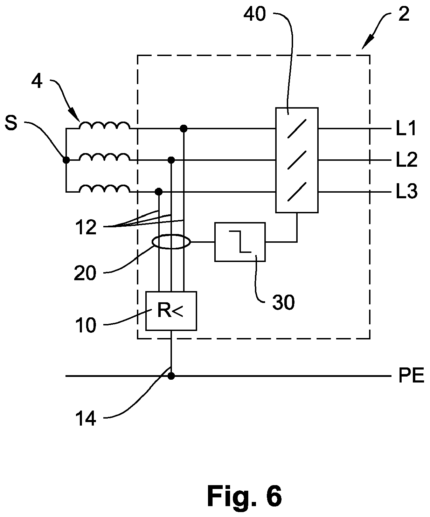

Die **Fig. 6** zeigt zunächst an dem Beispiel eines dreiphasigen Wechselstromstromversorgungssystems 4 eine erfindungsgemäße elektrische Schaltungsanordnung 2 bestehend aus einem normgerechten Isolationsüberwachungsgerät 10, einem allstromsensitiven Messstromwandler 20, einer Auswerteeinrichtung 30 und einer Schaltvorrichtung 40.

Das Isolationsüberwachungsgerät 10 ist über Ankoppelzweige 12 an jeweils einen aktiven Leiter L1, L2, L3 des Stromversorgungssystems 4 und über einen Erdanschlusszweig 14 an Erde PE angeschlossen.

Der Messstromwandler 20 ist vorzugsweise als Stromsensor mit einem Ringkern ausgeführt, wobei der Ringkern sämtliche Ankoppelzweige 12 umschließt, um den gesamten von dem Stromversorgungssystem 4 gegen Erde PE abgeleiteten Fehlerstrom zu umfassen.

Das Messergebnis des Messstromwandlers 20 wird einer Auswerteeinrichtung 30 zugeführt, die bei Überschreitung eines Fehlerstromgrenzwertes die Schaltvorrichtung 40 ansteuert, welche das zu überwachende Stromversorgungsystem 4 abschaltet.

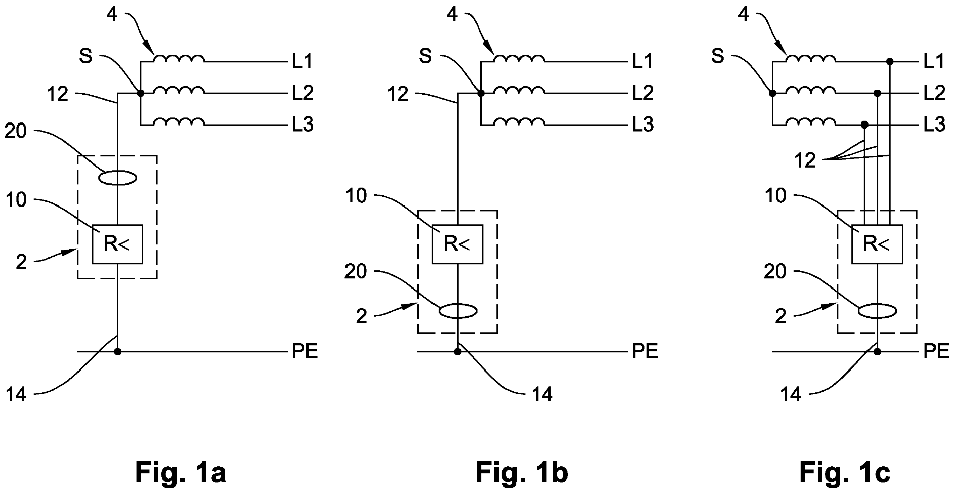

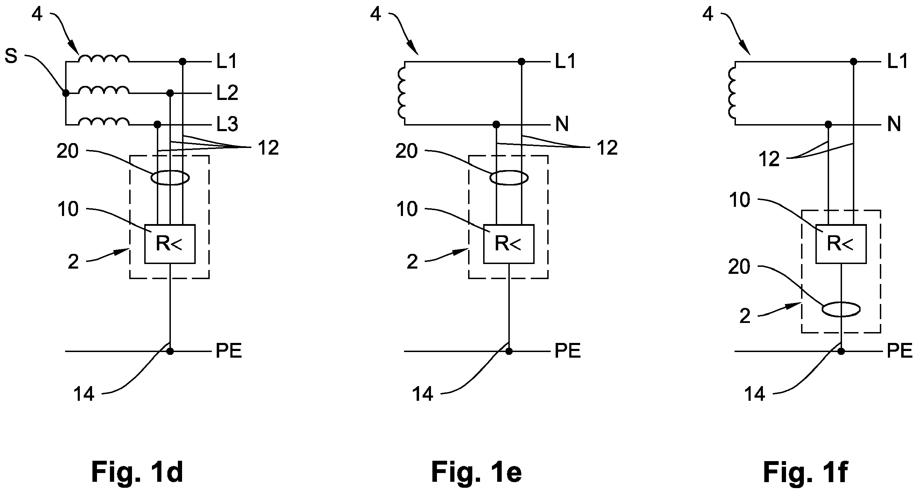

Die **Fig. 1** bis **5** zeigen verschiedene nachrüstbare Anordnungsmöglichkeiten des Messstromwandlers 20 in unterschiedlichen durch die Art des Stroms (AC, DC) und die Art und Anzahl der Leiter vorgegebenen Stromversorgungssystemen. Zur Vereinfachung der Darstellung sind in den Fig. 1 bis 5 die Auswerteeinrichtung 30 sowie die Schaltvorrichtung 40 nicht eingezeichnet, aber in der tatsächlichen Realisierung stets von der erfindungsgemäßen elektrischen Schaltungsanordnung 2, wie in Fig. 6 dargestellt, umfasst.

Die **Fig. 1a** bis **1f** betreffen mögliche nachrüstbare Anordnungen des Messstromwandlers 20 in Wechselstrom-Stromversorgungssystemen 4.

Die **Fig. 1a** und **1b** zeigen ein dreiphasiges Wechselstrom-Stromversorgungssystem 4 mit zugänglichem Sternpunkt S, wobei der Messstromwandler 20 entweder in dem Ankoppelzweig 12 (**Fig. 1a**) oder in dem Erdanschlusszweig 14 des Isolationsüberwachungsgerätes 10 (**Fig. 1b**) angeordnet ist.

Alternativ dazu, beispielsweise bei einem unzugänglichen Sternpunkt S und daher bei direktem Anschluss des Isolationswiderstandgerätes 10 über jeweils einen Ankoppelzweig 12 an jeweils einen aktiven Leiter L1, L2, L3 des Stromversorgungssystems 4, ist der Messstromwandler 20 in dem Erdanschlusszweig 14 (**Fig. 1c**) oder alle drei Ankoppelzweige 12 umfassend (**Fig. 1d**) in diesen Ankoppelzweigen 12 angeordnet.

Analog ist bei einem einphasigen Wechselstrom-Stromversorgungssystem 4 die Anordnung des Messstromwandlers 20 in den beiden Ankoppelzweigen 12 (**Fig. 1e**) oder in den Erdanschlusszweig 14 (**Fig. 1f**) möglich.

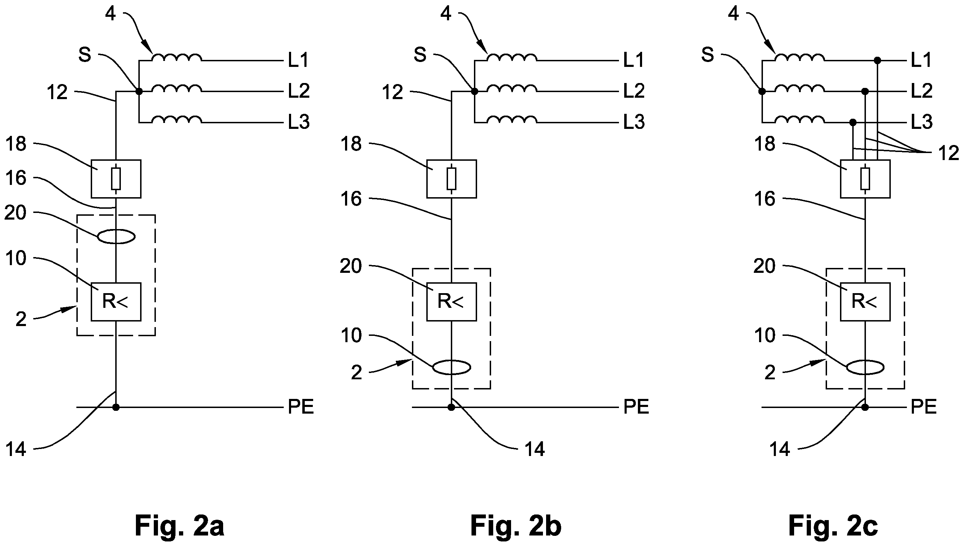

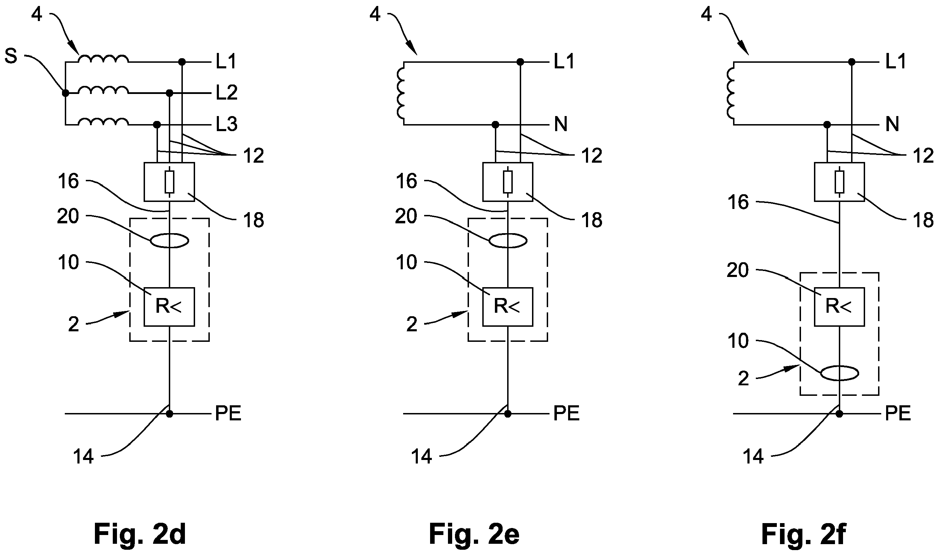

**Fig. 2** zeigt nachrüstbare Anordnungen des Messstromwandlers 20 in 3AC- und AC-Stromversorgungssystemen 4, in denen ein Ankoppelgerät 18 "vor" das Isolationsüberwachungsgerät 10 an die aktiven Leiter L1, L2, L3 bzw. L1, N angeschlossen ist.

Der Messstromwandler 20 ist bei zugänglichem Sternpunkt S in einem dreiphasigen Wechselstrom-Stromversorgungssystem 4 in einer Verbindungsleitung 16 (**Fig. 2a**) zwischen dem Ankoppelgerät 18 und dem Isolationsüberwachungsgerät 10 oder in dem Erdanschlusszweig 14 (**Fig. 2b**) angeordnet. Bei nicht zugänglichen Sternpunkt S und unmittelbar an die aktiven Leiter L1, L2, L3 bzw. L1, N angeschlossenem Ankoppelgerät 18 ist der Messstromwandler 20 entweder in dem Erdanschlusszweig 14 (**Fig. 2c**) oder in der Verbindungsleitung 16 (**Fig. 2d**) angeordnet.

Entsprechendes gilt in einem einphasigen Wechselstrom-Stromversorgungssystem 4, wo der Messstromwandler 20 entweder in die Verbindungsleitung 16 (**Fig. 1e**) oder in den Erdanschlusszweig 14 (**Fig. 2f**) geschaltet ist.

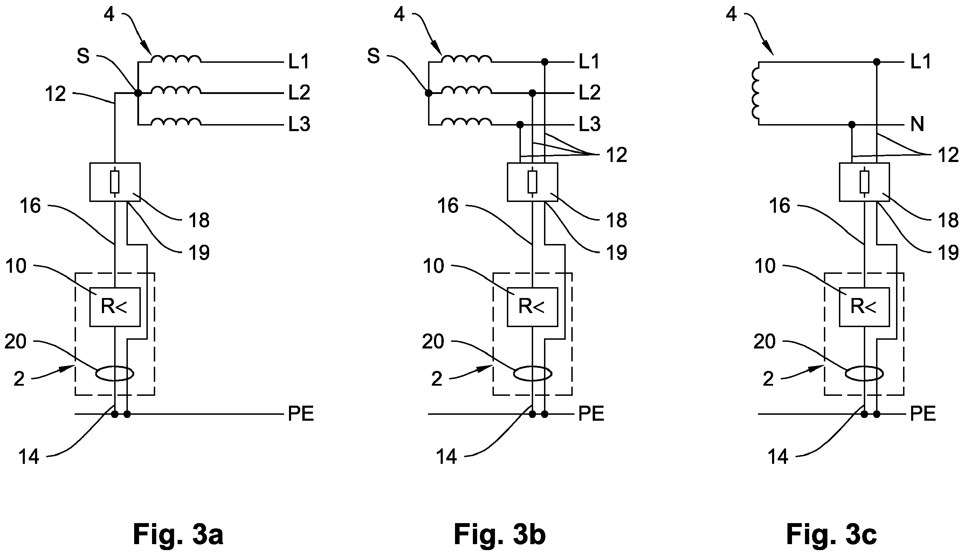

**Fig. 3** zeigt nachrüstbare Anordnungen des Messstromwandlers 20 in einem 3AC- und AC-Stromversorgungssystem 4 mit spannungsbegrenzendem Ankoppelgerät 18. Das Ankoppelgerät 18 weist in diesem Fall einen eigenen Ankoppelgerät-Erdanschluss 19 auf. Der über diesen Ankoppelgerät-Erdanschluss 19 fließende Fehlerstrom wird wie der in dem Erdanschlusszweig 14 des Isolationsüberwachungsgerätes 10 fließende Fehlerstrom von dem Messstromwandler 20 erfasst, indem der Ankoppelgerät-Erdanschluss 19 des Ankoppelgerätes 18 durch den Ringkern des Messstromwandlers 20 geführt wird.

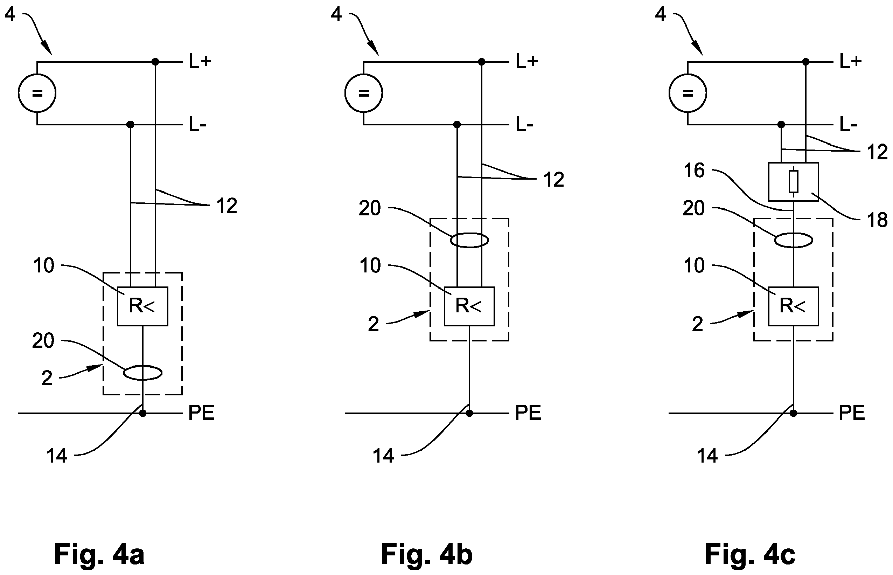

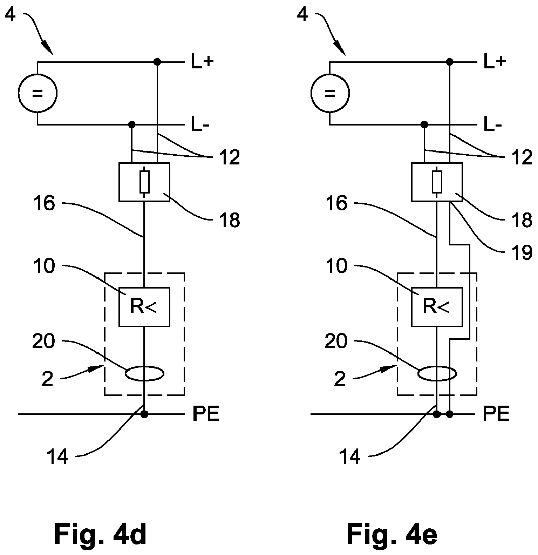

**Fig. 4** zeigt nachrüstbare Anordnungen des Messstromwandlers in einem Gleichstrom-Stromversorgungssystem 4.

Dabei ist der Messstromwandler 20 entweder in dem Erdanschlusszweig 14 (**Fig. 4a**) oder in den Ankoppelzweigen 12 (**Fig. 4b**) des Isolationsüberwachungsgerätes 10 angeordnet.

Entsprechende Anordnungen sind bei vorgeschaltetem Ankoppelgerät 18 in **Fig. 4c** - mit Messstromwandler 20 in der Verbindungsleitung 16 zwischen Ankoppelgerät 18 und Isolationsüberwachungsgerät 10 - und in **Fig. 4d** - mit Messstromwandler 20 in dem Erdanschlusszweig 14 - dargestellt.

Bei einem Ankoppelgerät 18 mit Spannungsbegrenzung ist ebenfalls dessen Ankoppelgerät-Erdanschluss 19 durch den Ringkern des Messstromwandlers 20 geführt (**Fig. 4e**), um neben dem durch das Isolationsüberwachungsgerät 10 fließenden Fehlerstrom auch den Ankoppelgerät-Fehlerstrom zu erfassen.

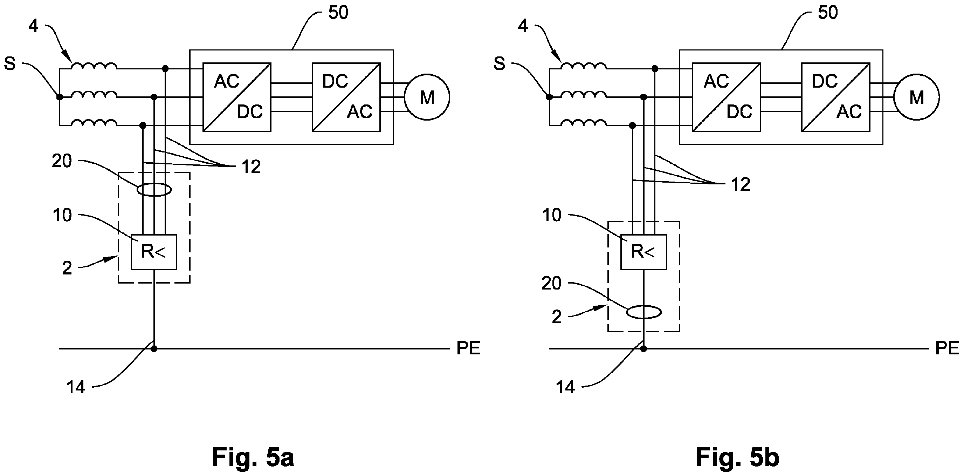

**Fig. 5** zeigt nachrüstbare Anordnungen des Messstromwandlers 20 in AC Stromversorgungssystemen 4 mit einem Frequenzumrichter 50.

Die in den Figuren 1 bis 6 dargestellten Nachrüstvarianten für den galvanisch getrennten, allstromsensitiven Messstromwandler 20 zur zusätzlichen und unabhängigen Erdschlussüberwachung in ungeerdeten Stromversorgungssystemen 4 mit einer Isolationsüberwachung entsprechend IEC 61557-8 können auch in kombinierten ungeerdeten AC/DC-Stromversorgungssystemen 4, also z.B. mit einem Frequenzumrichter 50 versehenen IT-Netzen, in gleicher Weise zum Einsatz kommen.

Je nachdem, ob das Isolationsüberwachungsgerät 10 an der AC-Einspeisung, im DC-Zwischenkreis oder am AC-Ausgang des Frequenzumrichters 50 angekoppelt werden soll, kann eine der zuvor dargestellten Varianten zur Anordnung des Messstromwandlers 20 gewählt werden.

Beim Einsatz der erfindungsgemäßen, zusätzlich zur Isolationsüberwachung eingebrachten Erdschlussüberwachung in IT-Stromversorgungssystemen 4 mit Frequenzumrichter 50 kommt zusätzlich zur Funktion der vorbeugenden, schnellen automatischen Abschaltung der Stromversorgung in einem als kritisch für das überwachte IT-Stromversorgungssystem erkannten Zustand eine Funktionalität, die einen Zustand erkennt, der zwar nicht kritisch für das überwachte IT-Stromversorgungssystem ist, jedoch kritisch für die Erfüllung der Isolationsüberwachungsfunktion durch das Isolationsüberwachungsgerät 10 sein kann. Beispiele hierfür sind
- hohe Stromamplituden in einem Frequenzbereich, für den das zum Einsatz kommende Isolationsüberwachungsgerät 10 nicht geeignet ist
- hohe Stromamplituden im schaltfrequenten Bereich des Frequenzumrichter 50, die zur Zerstörung des Isolationsüberwachungsgerätes 10 führen können
- Stromamplituden im DC-Bereich oder im niederfrequenten Bereich außerhalb der Spezifikation, die bei Ankopplung mit einem induktiven Ankoppelgerät zu Sättigungseffekten führen könnten.

Durch die Funktionalität einer zusätzlichen Erkennung von kritischen Zuständen außerhalb der Spezifikation des Isolationsüberwachungsgerätes 10 und/oder des Ankoppelgerätes 18 und entsprechend abgeleitete Maßnahmen, wie z.B. die Abgabe einer Alarmmeldung und/oder die vorbeugende automatische Abschaltung der Stromversorgung, werden auch Fehlanwendungen bzw. missbräuchliche Anwendungen der Komponenten zur Isolationsüberwachung auf eine sichere Art und risikominimierend gehandhabt. In Anwendungsfällen mit einem erhöhten Anspruch an funktionale Sicherheit ist die erfindungsgemäße elektrische Schaltungsanordnung 2 somit vorteilhaft anwendbar.

## Patentansprüche

1. Elektrische Schaltungsanordnung (2) zur normgerechten Isolationsüberwachung mit Schnellabschaltung bei Erdschlusserkennung für ein ungeerdetes Stromversorgungssystem (4),
mit einem normgerechten Isolationsüberwachungsgerät (10), welches netzseitig über jeweils einen Ankoppelzweig (12) an einen aktiven Leiter (L1, L2, L3) des Stromversorgungssystems (4) oder über einen Ankoppelzweig (12) an einen Sternpunkt (S) des Stromversorgungssystems (4) angeschlossen ist und erdseitig über einen Erdanschlusszweig (14) mit Erde (PE) verbunden ist,
**gekennzeichnet durch**
einen allstromsensitiven Messstromwandler (20), der einen Fehlerstrom netzseitig in den Ankoppelzweigen (12) an die aktiven Leiter (L1, L2, L3) oder in dem Ankoppelzweig (12) an den Sternpunkt (S) oder erdseitig in dem Erdanschlusszweig (14) des Isolationsüberwachungsgerätes (10) erfasst, eine Auswerteeinrichtung (30) zur Bewertung des Fehlerstroms im Hinblick auf eine Überschreitung eines Fehlerstrom-Grenzwertes und eine Schaltvorrichtung (40) zur Abschaltung des Stromversorgungssystems (4).

2. Elektrische Schaltungsanordnung (2) nach Anspruch 1,
**dadurch gekennzeichnet,**
**dass** bei der Verwendung eines Ankoppelgerätes (18), welches in den Ankoppelzweigen (12) an die aktiven Leiter (L1, L2, L3) oder in dem Ankoppelzweig (12) an den Sternpunkt (S) angeschlossen ist und über eine Verbindungsleitung (16) mit dem Isolationsüberwachungsgerät (10) verbunden ist, der Messstromwandler (20) den Fehlerstrom in dem Erdanschlusszweig (14) des Isolationsüberwachungsgerätes (10) oder in der Verbindungsleitung (16) erfasst.

3. Elektrische Schaltungsanordnung (2) nach Anspruch 2,
**dadurch gekennzeichnet,**
**dass** bei der Verwendung eines Ankoppelgerätes (18) mit einem Ankoppelgerät-Erdanschluss (19) der Messstromwandler (20) bei der Erfassung des Fehlerstroms in dem Erdanschlusszweig (14) des Isolationsüberwachungsgerätes (10) zusätzlich einen über den Ankoppelgerät-Erdanschluss (19) fließenden Ankoppelgerät-Fehlerstrom erfasst.
